# EUROPEAN PATENT APPLICATION

(11) **EP 4 734 701 A1**
(43) Date of publication of application: **29.04.2026**
(21) Application number: 24884002.7
(22) Date of filing: 01.07.2024
(51) Int. Cl.: H10D 86/00

(54) **DRIVING BACKPLANE, EPITAXIAL WAFER, PREPARATION METHOD, DISPLAY MODULE AND ELECTRONIC DEVICE**

(30) Priority: 30.10.2023 CN 202311435450
(71) Applicant: Huawei Technologies Co., Ltd., Shenzhen, Guangdong 518129 (CN)
(72) Inventor: LIU, Jinqiang, Shenzhen, Guangdong 518129 (CN); ZHANG, Li, Shenzhen, Guangdong 518129 (CN); JIANG, Fulong, Shenzhen, Guangdong 518129 (CN); YANG, Yina, Shenzhen, Guangdong 518129 (CN)
(74) Representative: Gill Jennings & Every LLP
(86) International application number: PCT/CN2024/102966
(87) International publication number: WO 2025/091994

(57) **Abstract**

This application relates to the field of electronic technologies, and provides a drive backplane, an epitaxial wafer, a preparation method, a display module, and an electronic device, to improve efficiency of a light-emitting device in the display module. The drive backplane includes a substrate, a drive circuit layer, a reflective layer, and a first bonding layer, where the drive circuit layer, the reflective layer, and the first bonding layer are sequentially provided on a same side of the substrate. The reflective layer includes a first dielectric layer and a second dielectric layer that are stacked, and the first dielectric layer and the second dielectric layer have different refractive indexes. Thicknesses, materials, and quantities of layers of the first dielectric layer and the second dielectric layer that are included in the reflective layer may vary between different drive backplanes. The first bonding layer is connected to the drive circuit layer, and is used to implement bonding between the drive backplane and the epitaxial wafer. When the drive backplane is used in the display module, a structure of the reflective layer may be adjusted based on a light-emitting wavelength of the light-emitting device, so that reflectivity of the reflective layer to red light, green light, and blue light can reach 90%, to improve efficiency of the light-emitting device.

## Description

This application claims priority to Chinese Patent Application No. 202311435450.9, filed with the China National Intellectual Property Administration on October 30, 2023 and entitled "DRIVE BACKPLANE, EPITAXIAL WAFER, PREPARATION METHOD, DISPLAY MODULE, AND ELECTRONIC DEVICE", which is incorporated herein by reference in its entirety.

### TECHNICAL FIELD

This application relates to the field of electronic technologies, and in particular, to a drive backplane, an epitaxial wafer, a preparation method, a display module, and an electronic device.

### BACKGROUND

A micro light-emitting diode (micro light-emitting diode, Micro LED) is an LED with a size less than 100 µm. The micro LED is a core light-emitting device of a micro display (micro display), and has currently become a research focus in the display field due to advantages such as fast response, autonomous light emitting, high brightness, low power consumption, high resolution, and high color saturation.

Currently, a display module including a micro LED is prepared by connecting a drive backplane to an epitaxial wafer of the micro LED by using a bonding technology. However, the display module that includes the micro LED and that is prepared by using a current mainstream bonding process suffers from problems such as low efficiency of the micro LED device.

### SUMMARY

Embodiments of this application provide a drive backplane, an epitaxial wafer, a preparation method, a display module, and an electronic device, to improve efficiency of a light-emitting device in the display module.

To achieve the foregoing objectives, the following technical solutions are used in this application.

According to a first aspect of an embodiment of this application, a drive backplane is provided, including a substrate, a drive circuit layer, a reflective layer, and a first bonding layer, where the drive circuit layer, the reflective layer, and the first bonding layer are sequentially provided on a same side of the substrate. The reflective layer includes a first dielectric layer and a second dielectric layer that are stacked, and the first dielectric layer and the second dielectric layer have different refractive indexes. Thicknesses, materials, and quantities of layers of the first dielectric layer and the second dielectric layer that are included in the reflective layer may vary between different drive backplanes. The first bonding layer is connected to the drive circuit layer through a conductive pillar, and is used to implement bonding between the drive backplane and an epitaxial wafer.

The reflective layer of the drive backplane includes one or more first dielectric layers and one or more second dielectric layers that are stacked. A quantity of layers, thicknesses, and materials for both the first dielectric layer and the second dielectric layer may be adjusted as required. When the drive backplane is used in a display module, structures of the first dielectric layer and the second dielectric layer may be adjusted based on a light-emitting wavelength of a light-emitting device in the display module, so that reflectivity of the reflective layer to red light, green light, and blue light can reach 90%, to improve efficiency of the light-emitting device in the display module. In addition, because a material of the reflective layer is an inorganic thin film material, and does not need to include a heavy metal material such as silver, there is no heavy metal pollution problem. The reflective layer is compatible with a standard production line process of the drive backplane, so that a processing process is simple, and mass production can be implemented at a low cost.

In a possible implementation, a material of the first bonding layer includes a transparent conductive material. The material of the first bonding layer in the drive backplane includes the transparent conductive material, and the transparent conductive material has high transmittance, so that transmittance of light reflected by the reflective layer can be further improved. In addition, because the first bonding layer does not include metal such as gold, there is no metal pollution problem. The first bonding layer is compatible with the standard production line process of the drive backplane, so that a processing process is simple, and mass production can be implemented at a low cost.

In a possible implementation, there are a plurality of first dielectric layers and a plurality of second dielectric layers, and the plurality of first dielectric layers and the plurality of second dielectric layers are alternately arranged. A structure of the reflective layer may be flexibly deformed, so that reflectivity of the reflective layer to visible light in different wavelength bands can be optimized as possible.

In a possible implementation, the first bonding layer covers the reflective layer. The drive backplane provided in this embodiment of this application is applicable to a scenario in which there is a non-alignment bonding requirement.

In a possible implementation, the first bonding layer includes a first patterned bonding area and a first dielectric area; the first patterned bonding area is arranged in the first dielectric area and extends through the first dielectric area in a thickness direction of the first dielectric area; and the drive circuit layer includes a back-end-of-line metal interconnect pad, and the first patterned bonding area is connected to the back-end-of-line metal interconnect pad through the conductive pillar. The drive backplane provided in this embodiment of this application is applicable to a scenario in which there is an alignment bonding requirement.

In a possible implementation, materials of the first dielectric layer and the second dielectric layer each include silicon oxide, titanium dioxide, tantalum pentoxide, or niobium pentoxide. The material selection is technically mature, without a need to develop a new dielectric material.

In a possible implementation, a material of the first dielectric area includes silicon oxide, silicon nitride, titanium dioxide, tantalum pentoxide, or niobium pentoxide. The material selection is technically mature, without a need to develop a new dielectric material.

In a possible implementation, a material of the first patterned bonding area includes indium tin oxide, aluminum zinc oxide, or transparent conductive oxide. The material selection is technically mature, without a need to develop a new transparent conductive material.

According to a second aspect of an embodiment of this application, an epitaxial wafer is provided, including a base, an epitaxial stack, and a second bonding layer, where the epitaxial stack and the second bonding layer are sequentially provided on a same side of the base. The second bonding layer is used to implement bonding between the epitaxial wafer and a drive backplane, and a material of the second bonding layer includes a transparent conductive material.

The material of the second bonding layer in the epitaxial wafer includes the transparent conductive material, and transmittance of the transparent conductive material is higher than transmittance of a metal material, so that efficiency of a light-emitting device can be further improved. In addition, because the second bonding layer does not include metal such as gold, there is no metal pollution problem, and mass production can be implemented at a low cost. In addition, the second bonding layer may be directly reused as an electrode layer, to simplify a film layer structure of the epitaxial wafer and simplify a preparation process.

In a possible implementation, the second bonding layer covers the epitaxial stack. The drive backplane provided in this embodiment of this application is applicable to a scenario in which there is a non-alignment bonding requirement.

In a possible implementation, the second bonding layer includes a second patterned bonding area and a second dielectric area, and the second patterned bonding area is arranged in the second dielectric area and extends through the second dielectric area in a thickness direction of the second dielectric area. The drive backplane provided in this embodiment of this application is applicable to a scenario in which there is an alignment bonding requirement.

In a possible implementation, a material of the second dielectric area includes silicon oxide, silicon nitride, titanium dioxide, tantalum pentoxide, or niobium pentoxide. The material selection is technically mature, without a need to develop a new dielectric material.

In a possible implementation, a material of the second patterned bonding area includes indium tin oxide, aluminum zinc oxide, or transparent conductive oxide. The material selection is technically mature, without a need to develop a new transparent conductive material.

In a possible implementation, the epitaxial stack includes a second semiconductor layer, an active layer, and a first semiconductor layer that are sequentially stacked on a side of the base. In a possible implementation, the epitaxial stack includes a plurality of light-emitting structures, one of the first semiconductor layer and the second semiconductor layer is an N-type semiconductor layer, and the other one of the first semiconductor layer and the second semiconductor layer is a P-type semiconductor layer. The light-emitting structure has a simple structure and a wide range of applications.

In a possible implementation, the epitaxial wafer further includes a first electrode layer, and the first electrode layer is provided between the second bonding layer and the epitaxial stack. A material of the first electrode layer and the material of the second bonding layer may be different.

According to a third aspect of an embodiment of this application, a display module is provided, including a substrate, and a drive circuit layer, a reflective layer, a bonding layer, and a plurality of light-emitting devices that are sequentially disposed on a side of the substrate. The reflective layer includes a first dielectric layer and a second dielectric layer that are stacked, the first dielectric layer and the second dielectric layer have different refractive indexes, and the bonding layer is connected to the light-emitting devices and is connected to the drive circuit layer through a conductive pillar.

In the display module provided in this embodiment of this application, the reflective layer includes one or more first dielectric layers and one or more second dielectric layers that are stacked. A quantity of layers, thicknesses, and materials for both the first dielectric layer and the second dielectric layer may be adjusted as required. Structures of the first dielectric layer and the second dielectric layer may be adjusted based on a light-emitting wavelength of the light-emitting device in the display module, so that reflectivity of the reflective layer to red light, green light, and blue light can reach 90%, to improve light emission efficiency of the display module. In addition, because a material of the reflective layer is an inorganic thin film material, and does not need to include a heavy metal material such as silver, there is no heavy metal pollution problem. The reflective layer is compatible with a standard production line process, so that a processing process is simple, and mass production can be implemented at a low cost.

In a possible implementation, a material of the bonding layer includes a transparent conductive material. The transparent conductive material has high transmittance, so that light emission efficiency of the display module can be further improved. In addition, because the bonding layer does not include metal such as gold, there is no metal pollution problem. The bonding layer is compatible with a standard production line process, so that a processing process is simple, and mass production can be implemented at a low cost.

In a possible implementation, the bonding layer includes a patterned bonding area and a dielectric area, and the patterned bonding area is arranged in the dielectric area and extends through the dielectric area in a thickness direction of the dielectric area. Materials of the patterned bonding area and the dielectric area are both transparent materials, so that efficiency of the light-emitting device can be further improved.

In a possible implementation, a value of a sum of a thickness of the bonding layer and a thickness of the reflective layer ranges from 100 nm to 2000 nm. Based on a feature of the bonding layer provided in this application, the thickness of the bonding layer may be less than 2000 nm, so that a subsequent etching process is easy to perform.

In a possible implementation, the light-emitting device includes a first semiconductor layer, an active layer, a second semiconductor layer, and a second electrode that are sequentially disposed in a direction away from the bonding layer, one of the first semiconductor layer and the second semiconductor layer is an N-type semiconductor layer, and the other one of the first semiconductor layer and the second semiconductor layer is a P-type semiconductor layer.

In a possible implementation, the light-emitting device further includes a first electrode, and the first electrode is disposed between the first semiconductor layer and the bonding layer. In this structure, the first electrode is an independent film layer, and the bonding layer is not reused as the first electrode, so that a limitation on the material of the bonding layer can be reduced.

According to a fourth aspect of an embodiment of this application, an electronic device is provided, including a display module and a processor, where the processor is configured to control the display module to display an image, and the display module includes the display module according to any implementation of the third aspect.

According to a fifth aspect of an embodiment of this application, a method for preparing a drive backplane is provided, including: forming a layer drive circuit layer on a substrate; forming a reflective layer on a side that is of the drive circuit layer and that is away from the substrate, where the reflective layer includes a first dielectric layer and a second dielectric layer that are stacked, and the first dielectric layer and the second dielectric layer have different refractive indexes; and forming a first bonding layer on a side that is of the reflective layer and that is away from the substrate, where the first bonding layer is connected to the drive circuit layer through a conductive pillar. Beneficial effects of the drive backplane obtained by using the preparation method provided in this embodiment of this application are the same as beneficial effects of the drive backplane provided in the first aspect. Details are not described herein again.

In a possible implementation, forming the first bonding layer on the side that is of the reflective layer and that is away from the substrate includes: depositing, on the side that is of the reflective layer and that is away from the substrate, the first bonding layer covering the reflective layer, where a material of the first bonding layer includes a transparent conductive material.

In a possible implementation, the first bonding layer includes a first patterned bonding area and a first dielectric area; and forming the first bonding layer on the side that is of the reflective layer and that is away from the substrate includes: depositing, on the side that is of the reflective layer and that is away from the substrate, a first bonding film covering the reflective layer, where a material of the first bonding film includes a transparent conductive material; patterning the first bonding film to form the first patterned bonding area, where the first patterned bonding area is coupled to a back-end-of-line metal interconnect pad in the drive circuit layer; and forming the first dielectric area on the side that is of the reflective layer and that is away from the substrate, where the first dielectric area encapsulates a side surface of the first patterned bonding area.

According to a sixth aspect of an embodiment of this application, a method for preparing an epitaxial wafer is provided, including: forming an epitaxial stack on a base; and forming a second bonding layer on a side that is of the epitaxial stack and that is away from the base, where a material of the second bonding layer includes a transparent conductive material. Beneficial effects of the epitaxial wafer obtained by using the preparation method provided in this embodiment of this application are the same as beneficial effects of the epitaxial wafer provided in the second aspect. Details are not described herein again.

In a possible implementation, forming the second bonding layer on the side that is of the epitaxial stack and that is away from the base includes: depositing, on the side that is of the epitaxial stack and that is away from the base, the second bonding layer covering the epitaxial stack. In this structure, the second bonding layer is reused as the first electrode layer, so that a preparation process of the epitaxial wafer can be simplified.

In a possible implementation, the second bonding layer includes a second patterned bonding area and a second dielectric area, and forming the second bonding layer on the side that is of the epitaxial stack and that is away from the base includes: forming a second bonding film on the side that is of the epitaxial stack and that is away from the base, where a material of the second bonding film is a transparent conductive material; patterning the second bonding film to form a plurality of second patterned bonding areas; and forming the second dielectric area on a side that is of the first electrode layer and that is away from the base, where the second dielectric area encapsulates a side surface of the second patterned bonding area. In this structure, a part of the second patterned bonding area is reused as the first electrode layer, so that the preparation process of the epitaxial wafer can be simplified.

In a possible implementation, before forming the second bonding layer on the side that is of the epitaxial stack and that is away from the base, the preparation method further includes: forming a first electrode layer on the side that is of the epitaxial stack and that is away from the base. In this structure, the epitaxial wafer includes the first electrode layer, so that a limitation on the material of the second bonding layer can be reduced.

### BRIEF DESCRIPTION OF DRAWINGS

FIG. 1 is a diagram of a structure of an electronic device according to an embodiment of this application;
FIG. 2A is a diagram of a process for preparing a display module according to an embodiment of this application;
FIG. 2B is a diagram of a process for preparing a display module according to an embodiment of this application;
FIG. 3A is a diagram of a structure of a drive backplane according to an embodiment of this application;
FIG. 3B is a diagram of a structure of an epitaxial wafer according to an embodiment of this application;
FIG. 3C is a diagram of a structure of a bonded wafer according to an embodiment of this application;
FIG. 4 is a schematic flowchart of preparing a drive backplane according to an embodiment of this application;
FIG. 5 to FIG. 9 are diagrams of a process for preparing a drive backplane according to an embodiment of this application;
FIG. 10 is a schematic flowchart of preparing an epitaxial wafer according to an embodiment of this application;
FIG. 11 to FIG. 13 are diagrams of a process for preparing a wafer according to an embodiment of this application;
FIG. 14A and FIG. 14B are diagrams of a structure of a bonded wafer according to an embodiment of this application;
FIG. 15 is a diagram of another process for preparing a drive backplane according to an embodiment of this application;
FIG. 16 is another schematic flowchart of preparing an epitaxial wafer according to an embodiment of this application;
FIG. 17 to FIG. 22 are diagrams of another process for preparing a wafer according to an embodiment of this application;
FIG. 23A and FIG. 23B are diagrams of another structure of a bonded wafer according to an embodiment of this application; and
FIG. 24A and FIG. 24B are diagrams of a structure of a display module according to an embodiment of this application.

### DESCRIPTION OF EMBODIMENTS

The following describes the technical solutions in embodiments of this application with reference to the accompanying drawings in embodiments of this application. It is clear that the described embodiments are merely a part rather than all of embodiments of this application.

The terms such as "first" and "second" below are only for ease of description, and cannot be understood as indicating or implying relative importance or implicitly indicating a quantity of indicated technical features. Therefore, a feature limited by "second", "first", or the like may explicitly or implicitly include one or more features. In the descriptions of this application, unless otherwise stated, "a plurality of" means two or more than two.

In embodiments of this application, orientation terms such as "upper", "lower", "left", and "right" may include but are not limited to definitions based on illustrated orientations in which components in the accompanying drawings are placed. It should be understood that these directional terms may be relative concepts, are used for description and clarification of relative locations, and may vary accordingly depending on a change in the orientations in which the components in the accompanying drawings are placed in the accompanying drawings.

In embodiments of this application, unless otherwise clearly specified and limited, a term "connection" should be understood in a broad sense. For example, the "connection" may be a fixed connection, a detachable connection, or an integrated connection, or may be a direct connection or an indirect connection implemented through an intermediate medium.

In embodiments of this application, "and/or" describes an association relationship between associated objects, and indicates that three relationships may exist. For example, A and/or B may indicate the following cases: Only A exists, both A and B exist, and only B exists, where A and B may be singular or plural. The character "/" generally indicates an "or" relationship between the associated objects.

An embodiment of this application provides an electronic device. The electronic device is, for example, a consumer electronic product, a home electronic product, a vehicle-mounted electronic product, or a financial terminal product that includes a display module. The consumer electronic product is, for example, a virtual reality (virtual reality, VR) electronic device, an augmented reality (augmented reality, AR) electronic device, a mixed reality (mixed reality, MR) electronic device, a mobile phone, a tablet computer, a notebook computer, or a personal digital assistant (personal digital assistant, PDA). The home electronic product is, for example, a smart door lock or a rechargeable small household appliance (for example, a soy milk maker or a sweeping robot). The vehicle-mounted electronic product is, for example, a vehicle-mounted navigator or a vehicle-mounted computer. A specific form of the electronic device is not specially limited in embodiments of this application.

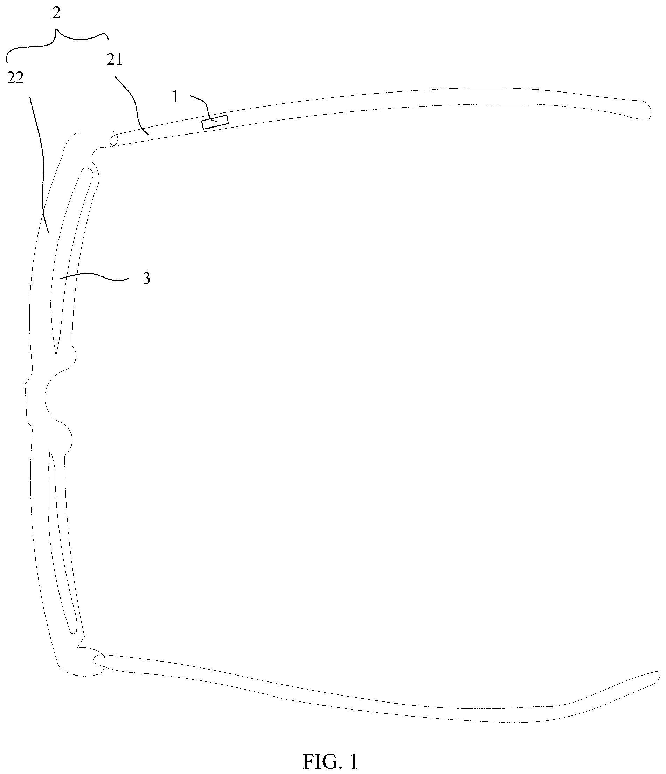

FIG. 1 is a diagram of a structure of an electronic device according to an embodiment of this application.

An AR electronic device is a wearable device that can be worn on a human head for display. The AR electronic device can superimpose virtual information onto a real world by using a computer technology, so that a real environment and a virtual object can be superimposed on a same image in real time, to implement mutual complementation of the two types of information, exchange visual information, auditory information, and the like, and display the image in front of a user through a helmet, glasses, or the like. This enhances the user's perception of reality.

For example, the electronic device is AR glasses. As shown in FIG. 1, the AR glasses include a display module 1, a frame 2, and lenses 3.

The frame 2 includes temples 21. The display module 1 may be disposed on a temple 21, that is, the display module 1 is disposed sideways. The lenses 3 are further mounted on the frame 2. For example, the frame 2 is fastened to the lenses 3. Alternatively, the frame 2 further includes a rim 22, and the lenses 3 are mounted in the rim 22.

In some embodiments, an optical waveguide structure is further integrated into the AR glasses, and the optical waveguide structure includes three parts: an incident light coupling part, a waveguide part, and an emergent light coupling part. For example, the optical waveguide structure is integrated into a lens 3. An optical signal sent by the display module 1 is coupled to the waveguide part through the incident light coupling part, the waveguide part adjusts a transmission direction of the light coupled to the waveguide part, and the adjusted light enters human eyes through the emergent light coupling part, so that the optical signal of the display module 1 is transmitted to entrance pupils of the human eyes.

The AR glasses may include one or more display modules 1. In this embodiment of this application, only an example in which the AR glasses include one display module 1 is used for description.

In some embodiments, the AR glasses further include a processor, and the processor is configured to control the display module 1 to display an image.

As a micro LED light-emitting chip, a micro light-emitting diode (micro light-emitting diode, Micro LED) is widely used in a micro display module 1 due to advantages such as fast response, autonomous light emitting, high brightness, low power consumption, high resolution, and high color saturation. How to mass-produce the display module 1 at a low cost is one of key factors for driving adoption of a micro LED technology. Currently, a display module including a micro LED is prepared by connecting a drive backplane to an epitaxial wafer by using a bonding technology.

In an implementation, bonding layers are respectively manufactured on the drive backplane and the epitaxial wafer, then the drive backplane and the epitaxial wafer are connected by using a bonding process, and finally a bonded wafer (wafer) is processed to form the display module 1.

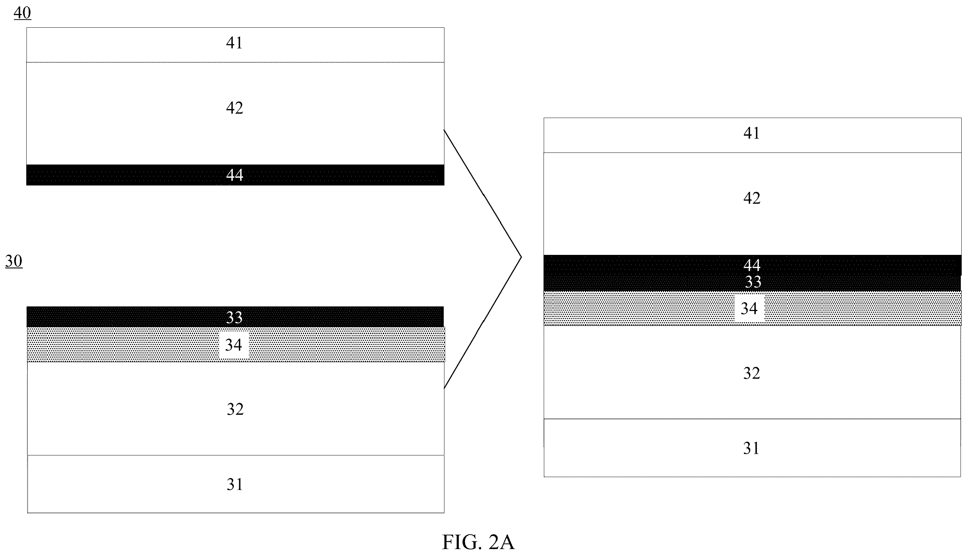

FIG. 2A is a diagram of a process for preparing a display module according to an embodiment of this application.

In some embodiments, as shown in FIG. 2A, a process for preparing the display module 1 includes: forming a drive backplane 30, where the drive backplane 30 includes a substrate 31, a drive circuit layer 32, a reflective layer 34 (a material is metal with high reflectivity, for example, silver (Ag)), and a first bonding layer 33 covering a surface of the reflective layer 34, and a material of the first bonding layer 33 includes a gold/tin (Au/Sn) alloy; forming an epitaxial wafer 40, where the epitaxial wafer 40 includes a base 41, an epitaxial stack 42', and a second bonding layer 44, and a material of the second bonding layer 44 includes a gold/tin alloy; bonding the first bonding layer 33 of the drive backplane 30 to the second bonding layer 44 of the epitaxial wafer 40, to form a bonded wafer; and processing the bonded wafer to form the display module 1 (this step is not shown in FIG. 2A).

In the foregoing process, the material of the first bonding layer 33 and the material of the second bonding layer 44 each include the gold/tin alloy. Reflectivity of a gold material to a visible light wavelength section is about 40% to 90%, and reflectivity to a red light wavelength section/a green light wavelength section/a blue light wavelength section differs greatly. Specifically, the reflectivity to the blue light wavelength section is about 30% to 40%, the reflectivity to the green light wavelength section is about 70%, and the reflectivity to the red light wavelength section is greater than 80%. In order to improve efficiency of a light-emitting device, the reflective layer 34 needs to be provided, to improve reflectivity, thereby improving efficiency of the light-emitting device. However, after the reflective layer 34 is provided, stacking the reflective layer 34, the first bonding layer 33, and the second bonding layer 44 does not improve the reflectivity to the visible light wavelength section satisfactorily.

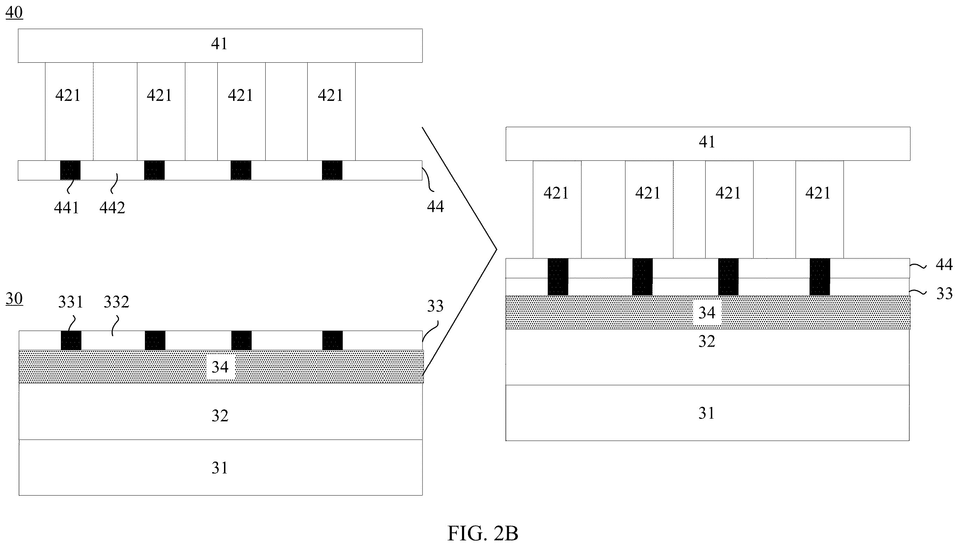

FIG. 2B is a diagram of a process for preparing a display module according to an embodiment of this application.

In some embodiments, as shown in FIG. 2B, a process for preparing a display module 1 includes: forming a drive backplane 30, where the drive backplane 30 includes a substrate 31, a drive circuit layer 32, a reflective layer 34 (a material is metal with high reflectivity, for example, silver), and a first bonding layer 33, the first bonding layer 33 includes a first patterned bonding area 331 and a first dielectric area 332 that encapsulates the first patterned bonding area 331, and a material of the first patterned bonding area 331 includes copper (Cu); forming an epitaxial wafer 40, where the epitaxial wafer 40 includes a base 41, a light-emitting structure 42, and a second bonding layer 44, the second bonding layer 44 includes a second patterned bonding area 441 and a second dielectric area 442 that encapsulates the second patterned bonding area 441, and a material of the second patterned bonding area 441 includes copper; bonding the first bonding layer 33 of the drive backplane 30 to the second bonding layer 44 of the epitaxial wafer 40, where the first patterned bonding area 331 and the second patterned bonding area 441 are aligned and bonded to each other, to form a bonded wafer; and processing the bonded wafer to form the display module 1 (this step is not shown in FIG. 2B).

In the foregoing process, the material of the first patterned bonding area 331 and the material of the second patterned bonding area 441 each include the copper. Reflectivity of a copper material to a visible light wavelength section is about 60% to 90%, and reflectivity to a red light wavelength section/a green light wavelength section/a blue light wavelength section differs greatly. Specifically, the reflectivity to the blue light wavelength section is about 60% to 70%, the reflectivity to the green light wavelength section is about 60% to 70%, and the reflectivity to the red light wavelength section is about 90%. In order to improve efficiency of a light-emitting device, the reflective layer 34 needs to be provided, to improve reflectivity, thereby improving efficiency of the light-emitting device. However, after the reflective layer 34 is provided, stacking the reflective layer 34, the first bonding layer 33, and the second bonding layer 44 does not improve the reflectivity to the visible light wavelength section satisfactorily.

Embodiments of this application provide a new drive backplane 30 and a new epitaxial wafer 40, to improve device efficiency of the display module 1.

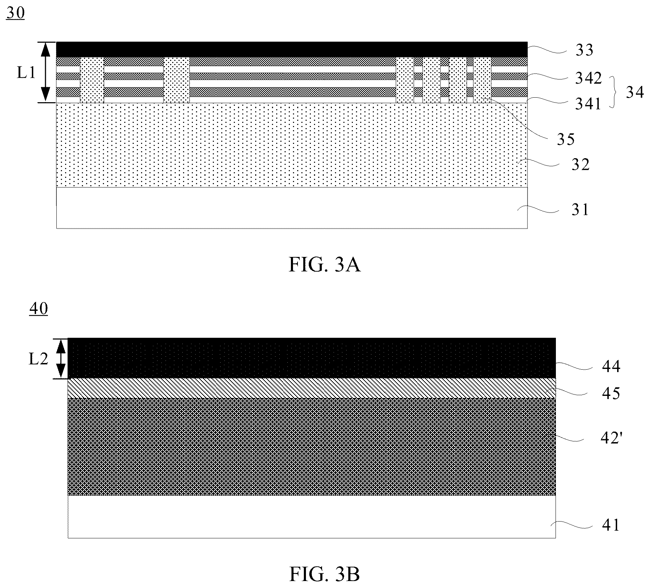

FIG. 3A is a diagram of a structure of a drive backplane according to an embodiment of this application.

An embodiment of this application provides the drive backplane 30. As shown in FIG. 3A, the drive backplane 30 includes a substrate 31, a drive circuit layer 32, a reflective layer 34, and a first bonding layer 33, where the drive circuit layer 32, the reflective layer 34, and the first bonding layer 33 are sequentially provided on a side of the substrate 31.

In some embodiments, the reflective layer 34 includes a first dielectric layer 341 and a second dielectric layer 342 that are stacked, and the first dielectric layer 341 and the second dielectric layer 342 have different refractive indexes.

For example, the first dielectric layer 341 and the second dielectric layer 342 have different materials, so that the first dielectric layer 341 and the second dielectric layer 342 have different refractive indexes.

Optionally, materials of the first dielectric layer 341 and the second dielectric layer 342 are both transparent dielectric materials. For example, the materials of the first dielectric layer 341 and the second dielectric layer 342 each include inorganic materials such as silicon oxide (SiO₂), titanium dioxide (TiO₂), tantalum pentoxide (Ta₂O₅), or niobium pentoxide (Nb₂O₅). In a possible implementation, the material of the first dielectric layer 341 is SiO₂, and the material of the second dielectric layer 342 is TiO₂. In another possible implementation, the material of the first dielectric layer 341 is SiO₂, and the material of the second dielectric layer 342 is Ta₂O₅. In still another implementation, the material of the first dielectric layer 341 is SiO₂, and the material of the second dielectric layer 342 is Nb₂O₅.

In some embodiments, the reflective layer 34 includes only one first dielectric layer 341 and one second dielectric layer 342, and the first dielectric layer 341 and the second dielectric layer 342 are stacked in a thickness direction of the drive backplane 30.

In some other embodiments, as shown in FIG. 3A, the reflective layer 34 includes a plurality of first dielectric layers 341 and a plurality of second dielectric layers 342, and the plurality of first dielectric layers 341 and the plurality of second dielectric layers 342 are alternately arranged in a thickness direction of the drive backplane 30.

Alternatively, it is understood that one first dielectric layer 341 and one second dielectric layer 342 are used as one repeating unit, the plurality of first dielectric layers 341 and the plurality of second dielectric layers 342 are divided into a plurality of repeating units, and the plurality of repeating units are stacked in the thickness direction of the drive backplane 30. Thicknesses of first dielectric layers 341 in all repeating units may be equal or may not be equal. Thicknesses of second dielectric layers 342 in all repeating units may be equal or may not be equal.

For example, materials of the first dielectric layers 341 in all repetition periodicities are the same, and materials of the second dielectric layers 342 in all repeating units are the same.

In the drive backplane 30 provided in this embodiment of this application, the reflective layer 34 includes one or more first dielectric layers 341 and one or more second dielectric layers 342 that are stacked. A quantity of layers, thicknesses, and materials for both the first dielectric layers 341 and the second dielectric layers 342 may be adjusted as required. When the drive backplane 30 is used in the display module 1, structures of the first dielectric layer 341 and the second dielectric layer 342 may be adjusted based on a light-emitting wavelength of a light-emitting device in the display module 1, so that reflectivity of the reflective layer 34 to red light, green light, and blue light can reach 90%, to improve efficiency of the light-emitting device in the display module 1. In addition, because a material of the reflective layer 34 is an inorganic thin film material, and does not need to include a heavy metal material such as silver (Ag), there is no heavy metal pollution problem. The reflective layer is compatible with a standard production line process of the drive backplane 30, so that a processing process is simple, and mass production can be implemented at a low cost.

In some embodiments, the first bonding layer 33 is connected to the drive circuit layer 32 through a conductive pillar. For example, the drive backplane 30 includes a first conductive pillar 35 that penetrates the reflective layer 34 in a thickness direction of the reflective layer 34, and two ends of the first conductive pillar 35 are respectively connected to the first bonding layer 33 and the drive circuit layer 32, to implement a connection between the first bonding layer 33 and the drive circuit layer 32.

For example, the material of the first bonding layer 33 includes metal.

Alternatively, for example, the material of the first bonding layer 33 includes a transparent conductive material.

For example, the material of the first bonding layer 33 includes indium tin oxide (indium tin oxide, ITO), aluminum zinc oxide (aluminum zinc oxide, AZO), transparent conductive oxide (transparent conductive oxide, TCO), and the like.

In this embodiment of this application, the material of the first bonding layer 33 in the drive backplane 30 includes the transparent conductive material, and transmittance of the transparent conductive material is higher than transmittance of the metal material, so that efficiency of the light-emitting device can be further improved. In addition, because the first bonding layer 33 does not include metal such as gold (Au), there is no metal pollution problem. The first bonding layer is compatible with the standard production line process of the drive backplane 30, so that a processing process is simple, and mass production can be implemented at a low cost.

FIG. 3B is a diagram of a structure of an epitaxial wafer according to an embodiment of this application.

An embodiment of this application provides an epitaxial wafer 40. As shown in FIG. 3B, the epitaxial wafer 40 includes a base 41, an epitaxial stack 42', a first electrode layer 45, and a second bonding layer 44. The epitaxial stack 42', the first electrode layer 45, and the second bonding layer 44 are sequentially provided on a side of the base 41.

The second bonding layer 44 is connected to the first electrode layer 45, and a material of the second bonding layer 44 includes a transparent conductive material.

For example, the material of the second bonding layer 44 includes ITO, AZO, TCO, and the like. In some embodiments, a material of the first bonding layer 33 is the same as the material of the second bonding layer 44.

In some embodiments, a material of the first electrode layer 45 includes a transparent conductive material. For example, the material of the first electrode layer 45 includes ITO, AZO, TCO, and the like. For example, the material of the first electrode layer 45 is the same as the material of the second bonding layer 44.

In some embodiments, the first electrode layer 45 and the second bonding layer 44 are an integrated structure, and the first electrode layer 45 and the second bonding layer 44 are synchronously prepared by using a same process.

For example, the second bonding layer 44 is reused as the first electrode layer 45. Alternatively, a part of the second bonding layer 44 is used as the first electrode layer 45. In this structure, a film layer structure of the epitaxial wafer 40 is simple, so that a preparation process can be further simplified.

In this embodiment of this application, the material of the second bonding layer 44 in the epitaxial wafer 40 includes the transparent conductive material, and transmittance of the transparent conductive material is higher than transmittance of a metal material, so that efficiency of the light-emitting device can be further improved. In addition, because the second bonding layer 44 does not include metal such as gold (Au), there is no metal pollution problem, and mass production can be implemented at a low cost.

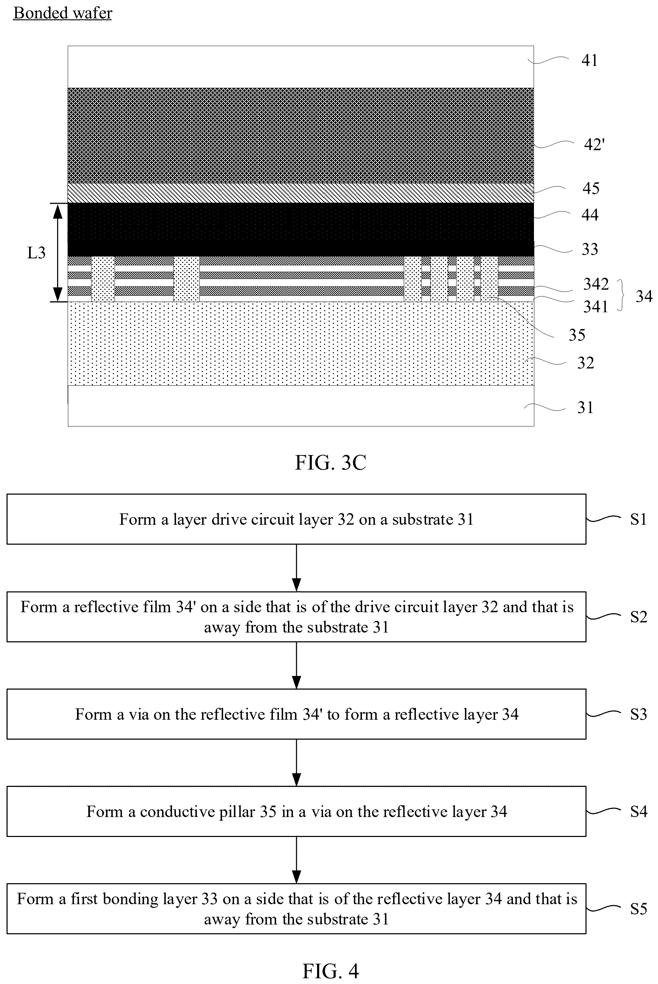

FIG. 3C is a diagram of a structure of a bonded wafer according to an embodiment of this application.

As shown in FIG. 3C, a first bonding layer 33 is prepared on a drive backplane 30, a second bonding layer 44 is prepared on an epitaxial wafer 40, and the first bonding layer 33 and the second bonding layer 44 are bonded to form a bonded wafer, to implement a connection between the drive backplane 30 and the epitaxial wafer 40.

In some embodiments, a value of a sum L3 of a thickness of a reflective layer 34 and a thickness of the bonded first bonding layer 33 and second bonding layer 44 are ranges from 100 nm to 2000 nm. For example, the value of the sum L3 of the thicknesses is 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1000 nm, 1100 nm, 1200 nm, 1300 nm, 1400 nm, 1500 nm, 1600 nm, 1700 nm, 1800 nm, or 1900 nm.

Based on a structure of the first bonding layer 33, the second bonding layer 44, and the reflective layer 34 provided in this application, the sum L3 of the thickness of the reflective layer 34 and the thickness of the bonded first bonding layer 33 and second bonding layer 44 may be less than 2000 nm, so that a subsequent etching process is easy to perform.

The following describes an example of a method for preparing a drive backplane 30 and a method for preparing an epitaxial wafer 40 that are provided in embodiments of this application.

### Example 1

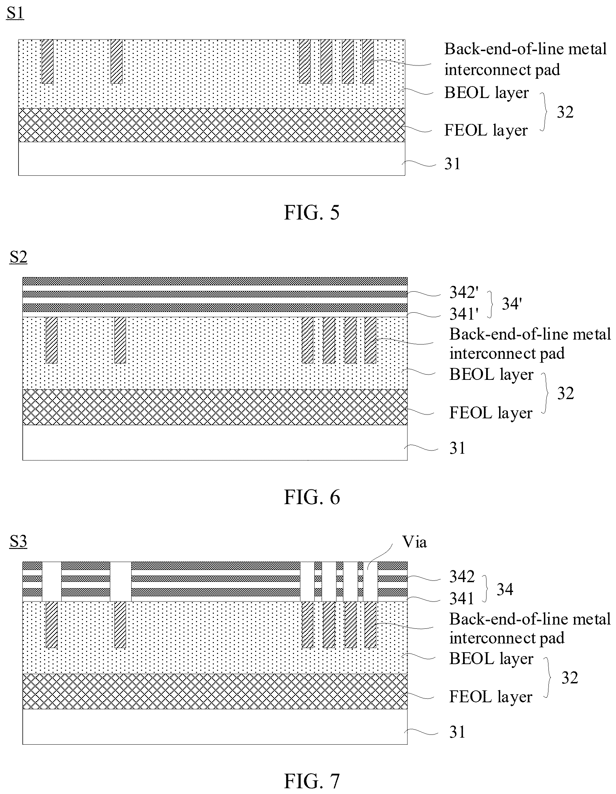

FIG. 4 is a schematic flowchart of preparing a drive backplane according to an embodiment of this application. FIG. 5 to FIG. 9 are diagrams of a process for preparing a drive backplane according to an embodiment of this application.

An embodiment of this application provides a method for preparing a drive backplane. As shown in FIG. 4, the preparation method includes the following steps.

S1: Form a layer drive circuit layer 32 on a substrate 31, as shown in FIG. 5.

For example, the substrate 31 is a monocrystalline silicon (Si) substrate, and the drive circuit layer 32 is formed on the substrate 31 by using a complementary metal oxide semiconductor (complementary metal oxide semiconductor, CMOS) process. For example, a structure such as a transistor is formed by using a front-end-of-line (front-end-of-line, FEOL) process, and is used as an FEOL layer of a drive backplane 30. A structure such as a wiring layer, a via, and a back-end-of-line metal interconnect pad (Pad) is formed by using a back-end-of-line (back-end-of-line, BEOL) process, and is used as a BEOL layer of the drive backplane 30. The drive circuit layer 32 includes a plurality of back-end-of-line metal interconnect pad and the like.

S2: Form a reflective film 34' on a side that is of the drive circuit layer 32 and that is away from the substrate 31, as shown in FIG. 6.

The reflective film 34' includes a first dielectric film 341' and a second dielectric film 342' that are stacked. When the reflective film 34' includes a plurality of first dielectric films 341' and a plurality of second dielectric films 342', the plurality of first dielectric films 341' and the plurality of second dielectric films 342' are alternately arranged.

For example, the first dielectric film 341' and the second dielectric film 342' in the reflective film 34' have different materials or thicknesses. The plurality of first dielectric films 341' may have a same material but different thicknesses. The plurality of second dielectric films 342' may have a same material but different thicknesses.

For example, a material of the first dielectric film 341' is SiO₂, and a material of the second dielectric film 342' is TiO₂. Alternatively, for example, a material of the first dielectric film 341' is SiO₂, and a material of the second dielectric film 342' is Ta₂O₅. Alternatively, for example, a material of the first dielectric film 341' is SiO₂, and a material of the second dielectric film 342' is Nb₂O₅.

In embodiments of this application, a quantity of layers, thicknesses, and materials for both the first dielectric film 341' and the second dielectric film 342' in a reflective layer 34 are not limited, and may be adjusted with reference to expected reflectivity of the reflective layer 34. In FIG. 6, an example in which the reflective layer 34 includes the plurality of first dielectric films 341' and the plurality of second dielectric films 342' that are stacked is used for illustration.

S3: Form a via on the reflective film 34' to form the reflective layer 34, as shown in FIG. 7.

The via passes through the reflective film 34' and communicates with the back-end-of-line metal interconnect pad in the drive circuit layer 32. For example, the reflective film 34' is patterned by using an exposure, development, and etching process, to form the reflective layer 34.

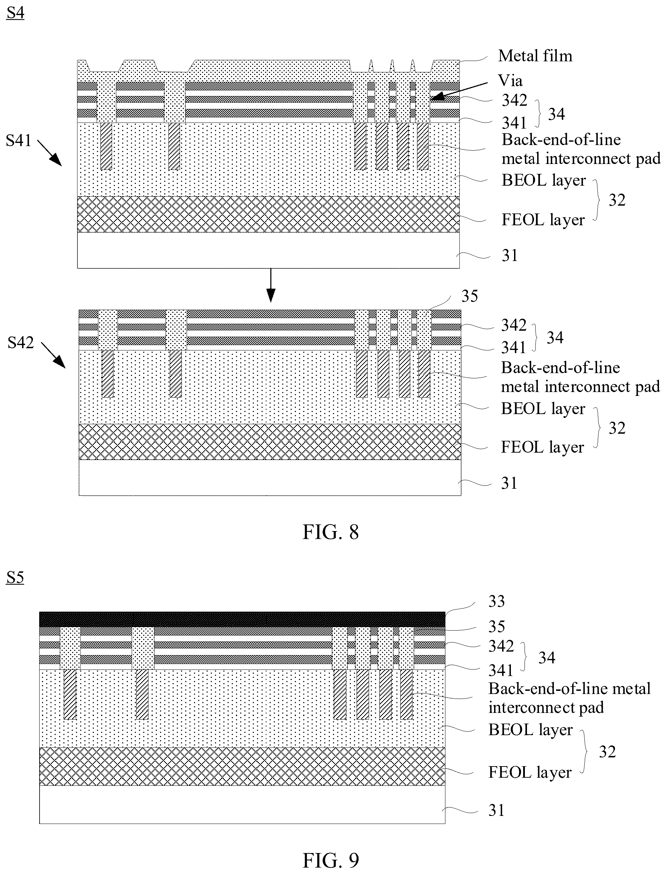

S4: Form a first conductive pillar 35 in a via on the reflective layer 34, as shown in FIG. 8.

For example, step S4 includes the following steps.

S41: Deposit a metal film on the reflective layer 34, where the metal film fills the via, is connected to the back-end-of-line metal interconnect pad, and covers the reflective layer 34.

For example, a material of the metal film includes metal with low impedance and a good hole filling effect, such as aluminum (Al) and tungsten (W).

S42: Flatten the metal film by using an etching or chemical mechanical polishing process, remove a metal film on a surface of the reflective layer 34, and retain a metal film in the via, to form the first conductive pillar 35. A material of the first conductive pillar 35 includes metal such as aluminum and tungsten.

S5: Form a first bonding layer 33 on a side that is of the reflective layer 34 and that is away from the substrate 31, as shown in FIG. 9.

For example, step S5 includes: depositing, on the side that is of the reflective layer 34 and that is away from the substrate 31, the first bonding layer 33 that covers the reflective layer 34 and the first conductive pillar 35, where the first bonding layer 33 is connected to the first conductive pillar 35, and the first bonding layer 33 is connected to the back-end-of-line metal interconnect pad in the drive circuit layer 32 through the first conductive pillar 35.

In some embodiments, the first bonding layer 33 covers the reflective layer 34 and the first conductive pillar 35, and a material of the first bonding layer 33 is a transparent conductive material.

Now, the drive backplane 30 provided in this embodiment of this application is prepared completely. The entire first bonding layer 33 in the drive backplane 30 provided in this example is a structure made of a conductive material. When the drive backplane 30 and the epitaxial wafer 40 are subsequently bonded, bonding may be performed by using a non-alignment process, so that a process difficulty can be reduced.

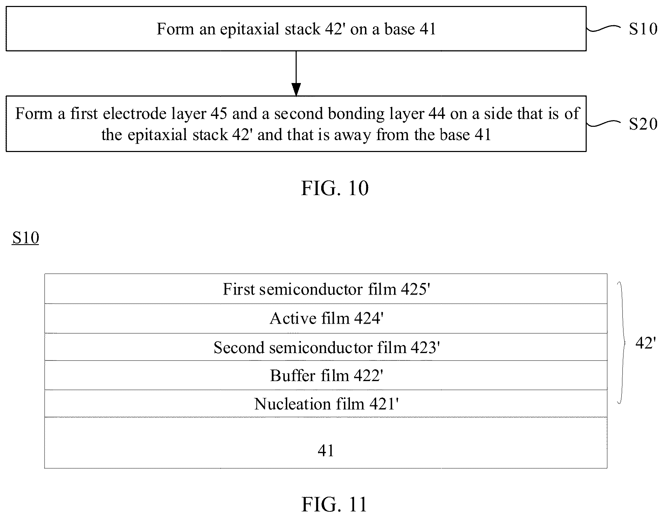

FIG. 10 is a schematic flowchart of preparing an epitaxial wafer according to an embodiment of this application. FIG. 11 to FIG. 13 are diagrams of a process for preparing a wafer according to an embodiment of this application.

An embodiment of this application provides a method for preparing an epitaxial wafer 40. As shown in FIG. 10, the preparation method includes the following steps.

S10: Form an epitaxial stack 42' on a base 41, as shown in FIG. 11.

The base 41 includes, for example, a sapphire substrate, a gallium nitride (GaN) substrate, a silicon carbide (SiC) substrate, a monocrystalline silicon substrate, a zinc oxide (ZnO) substrate, and the like.

In some embodiments, step S10 includes the following steps.

S101: Form a nucleation film 421' on the base 41.

For example, the nucleation film 421' may be formed by a metal-organic chemical vapor deposition (metal-organic chemical vapor deposition, MOCVD) process or a molecular beam epitaxy (molecular beam epitaxy, MBE) process.

A material of the nucleation film 421' may include, for example, one or more of GaN, aluminum gallium nitride (AlGaN), and aluminum nitride (AlN).

S102: Form a buffer film 422' on a side that is of the nucleation film 421' and that is away from the base 41.

For example, a graded AlGaN layer whose Al (aluminum) components gradually decrease may be epitaxially grown by using an MOCVD process.

The buffer film 422' may be a graded buffer layer, or the buffer film 422' may be a GaN layer, an AlN/GaN superlattice structure layer, or a combination of the foregoing several structures.

S103: Form a second semiconductor film 423' on a side that is of the buffer film 422' and that is away from the base 41.

For example, the second semiconductor film 423' is formed by using the MOCVD process or the MBE process.

S104: Form an active film 424' on a side that is of the second semiconductor film 423' and that is away from the base 41.

The active film 424' is used to emit light of different colors. A material of the active film 424' includes, for example, indium gallium nitride (InGaN), and emits the light of different colors by adjusting an In component in the InGaN.

S105: Form a first semiconductor film 425' on a side that is of the active film 424' and that is away from the base 41.

For example, the first semiconductor film 425' is formed by using the MOCVD process or the MBE process.

In some embodiments, one of the second semiconductor film 423' and the first semiconductor film 425' is an N-type semiconductor film and the other one of the second semiconductor film 423' and the first semiconductor film 425' is a P-type semiconductor film.

For example, the second semiconductor film 423' may be an N-type semiconductor film. For example, the N-type semiconductor film may be formed through doping in a semiconductor material, for example, gallium nitride. In the N-type semiconductor film, free electrons are majority carriers and holes are minority carriers; and conductivity is primarily implemented by free electrons. The higher concentration of the free electrons, the stronger conductivity of the N-type semiconductor film.

The first semiconductor film 425' may be a P-type semiconductor film. For example, the P-type semiconductor film may be formed through doping in a semiconductor material, for example, gallium nitride. In the P-type semiconductor film, holes are majority carriers and free electrons are minority carriers; and conductivity is primarily implemented by holes. The higher concentration of the holes, the stronger conductivity of the P-type semiconductor film.

In some embodiments, the epitaxial stack 42' includes the nucleation film 421', the buffer film 422', the second semiconductor film 423', the active film 424', and the first semiconductor film 425'. A structure of the epitaxial stack 42' provided in this embodiment of this application is merely an example, and a film layer may be added or reduced based on the foregoing structure. For example, the epitaxial stack 42' includes only the first semiconductor film 425', the active film 424', and the second semiconductor film 423'. When an epitaxial wafer is bonded to a drive backplane by using a non-alignment process, the first semiconductor film 425', the active film 424', and the second semiconductor film 423' are respectively used as a first semiconductor layer 425, an active layer 424, and a second semiconductor layer 423 of the epitaxial stack 42'.

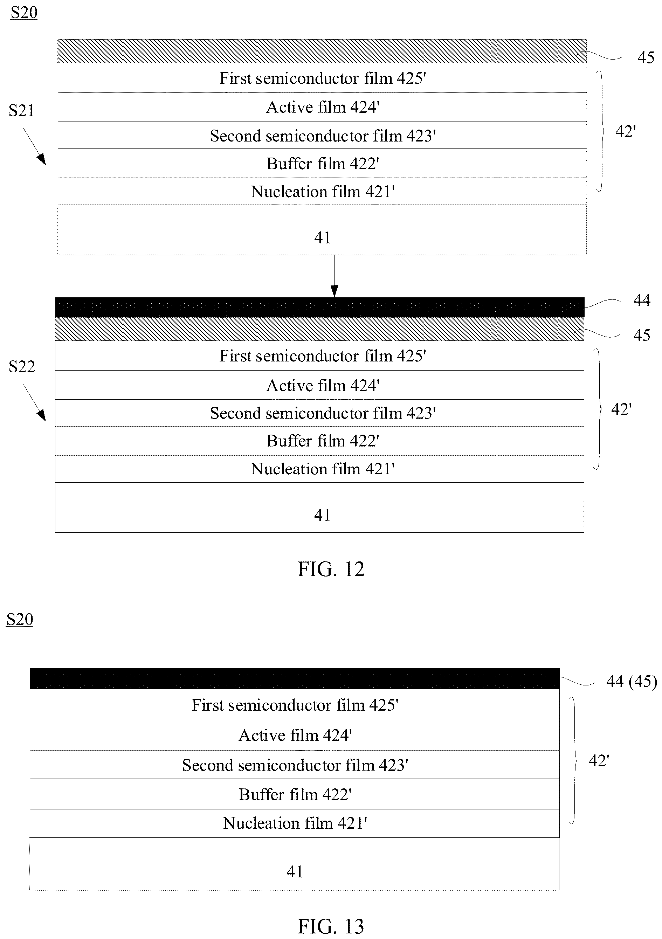

S20: Form a first electrode layer 45 and a second bonding layer 44 on a side that is of the epitaxial stack 42' and that is away from the base 41, as shown in FIG. 12 and FIG. 13.

In some embodiments, as shown in FIG. 12, step S20 includes the following steps.

S21: Form the first electrode layer 45 on the side that is of the epitaxial stack 42' and that is away from the base 41.

For example, a material of the first electrode layer 45 includes a transparent conductive material. The first electrode layer 45 is provided on a surface of the first semiconductor film 425', and is connected to the first semiconductor film 425'. When the first semiconductor film 425' is a P-type semiconductor layer, the first electrode layer 45 connected to the first semiconductor film 425' is a P electrode.

S22: Form the second bonding layer 44 on a side that is of the first electrode layer 45 and that is away from the base 41.

For example, step S22 includes: depositing, on the side that is of the first electrode layer 45 and that is away from the base 41, the second bonding layer 44 covering the first electrode layer 45. In some embodiments, the second bonding layer 44 covers the first electrode layer 45.

The second bonding layer 44 is connected to the first electrode layer 45. For example, the second bonding layer 44 is formed on a surface of the first electrode layer 45, and is in contact with the first electrode layer 45. A material of the second bonding layer 44 includes, for example, a transparent conductive material.

In this structure, the material of the first electrode layer 45 and the material of the second bonding layer 44 may be different, thereby reducing a requirement for material consistency.

In some other embodiments, as shown in FIG. 13, step S20 includes the following steps.

The second bonding layer 44 is formed on the side that is of the epitaxial stack 42' and that is away from the base 41, and the second bonding layer 44 is reused as the first electrode layer 45. For example, a material of the second bonding layer 44 includes a transparent conductive material.

In this structure, the first electrode layer 45 and the second bonding layer 44 can be formed by using one process, so that a preparation process of the epitaxial wafer can be simplified.

As shown in FIG. 12 and FIG. 13, in this example, the second bonding layer 44, the first electrode layer 45, and the epitaxial stack 42' are not patterned.

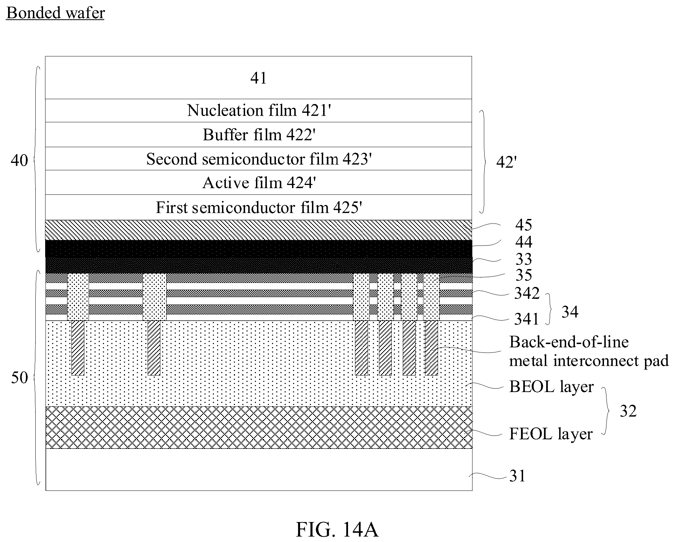

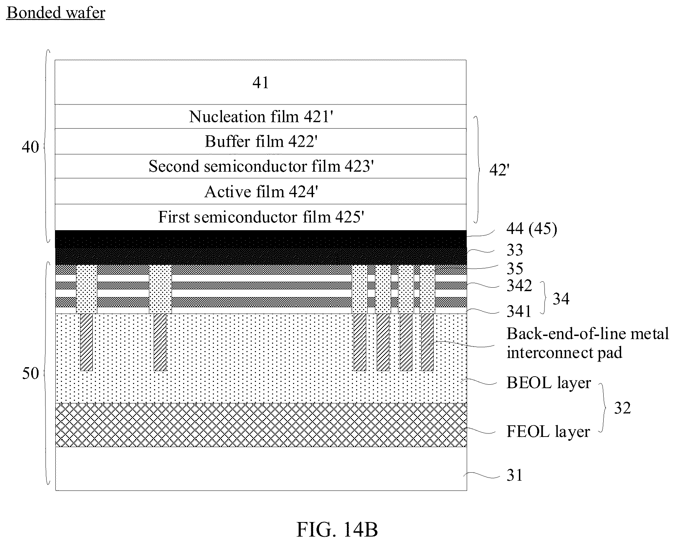

Now, the epitaxial wafer 40 provided in this embodiment of this application is prepared completely. The entire second bonding layer 44 in the epitaxial wafer 40 provided in this example is a structure made of a conductive material, as shown in FIG. 14A and FIG. 14B. When the drive backplane 30 and the epitaxial wafer 40 are bonded, the first bonding layer 33 and the second bonding layer 44 may be bonded by using a non-alignment process, to reduce a process difficulty.

### Example 2

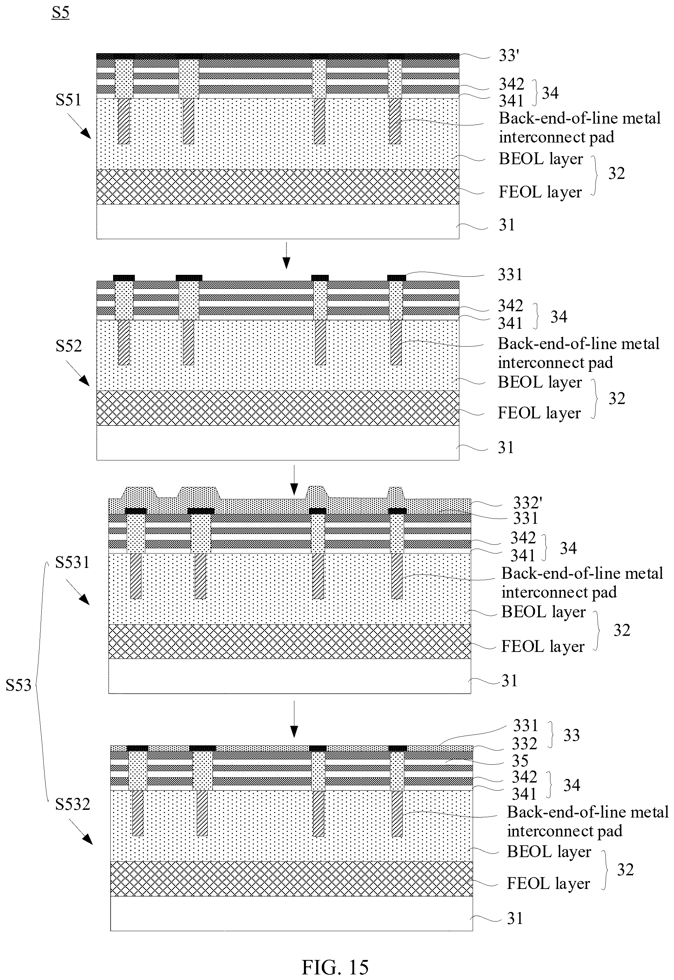

FIG. 15 is a diagram of a process for preparing a drive backplane according to an embodiment of this application.

An embodiment of this application provides a method for preparing a drive backplane. As shown in FIG. 4, the preparation method includes the following steps.

S1: Form a layer drive circuit layer 32 on a substrate 31, as shown in FIG. 5.

S2: Form a reflective film 34' on a side that is of the drive circuit layer 32 and that is away from the substrate 31, as shown in FIG. 6.

S3: Form a via on the reflective film 34' to form a reflective layer 34, as shown in FIG. 7.

S4: Form a first conductive pillar 35 in a via on the reflective layer 34, as shown in FIG. 8.

Steps S1 to S4 are the same as steps S1 to S4 in Example 1. Refer to the foregoing related descriptions. Details are not described herein again.

S5: Form a first bonding layer 33 on a side that is of the reflective layer 34 and that is away from the substrate 31, as shown in FIG. 15.

In some embodiments, step S5 includes the following steps.

S51: Deposit, on the side that is of the reflective layer 34 and that is away from the substrate 31, a first bonding film 33' that covers the reflective layer 34 and the first conductive pillar 35, where a material of the first bonding film 33' includes a transparent conductive material.

S52: Pattern the first bonding film 33' to form a first patterned bonding area 331.

The first patterned bonding area 331 is connected to the drive circuit layer 32 through the first conductive pillar 35, and a structure of the first patterned bonding area 331 is in a one-to-one correspondence with a back-end-of-line metal interconnect pad in the drive circuit layer 32.

S53: Form a first dielectric area 332 on the side that is of the reflective layer 34 and that is away from the substrate 31.

The first dielectric area 332 fills a gap area outside the first patterned bonding area 331, and encapsulates a side surface of the first patterned bonding area 331, to implement electrical insulation.

For example, step S53 includes the following steps.

S531: Deposit, on the side that is of the reflective layer 34 and that is away from the substrate 31, a third dielectric film 332' that covers the first patterned bonding area 331 and the reflective layer 34.

S532: Flatten the third dielectric film 332' by using an etching or chemical mechanical polishing process, to implement surface flatness of the third dielectric film 332', so as to form the first dielectric area 332.

As shown in FIG. 15, the drive backplane 30 includes the substrate 31, the drive circuit layer 32, the reflective layer 34, and the first bonding layer 33. The first bonding layer 33 includes the first patterned bonding area 331 and the first dielectric area 332. The first patterned bonding area 331 is arranged in the first dielectric area 332 and extends through the first dielectric area 332 in a thickness direction of the first dielectric area 332. The first patterned bonding area 331 may be connected to the back-end-of-line metal interconnect pad in the drive circuit layer 32 through the first conductive pillar 35.

For example, a material of the first dielectric area 332 includes an inorganic material such as silicon dioxide (SiO₂) and silicon nitride (SiN).

Now, the drive backplane 30 provided in this embodiment of this application is prepared completely. The first bonding layer 33 in the drive backplane 30 provided in this example is a patterned structure. When the drive backplane 30 and the epitaxial wafer 40 are subsequently bonded, bonding may be performed by using an alignment process.

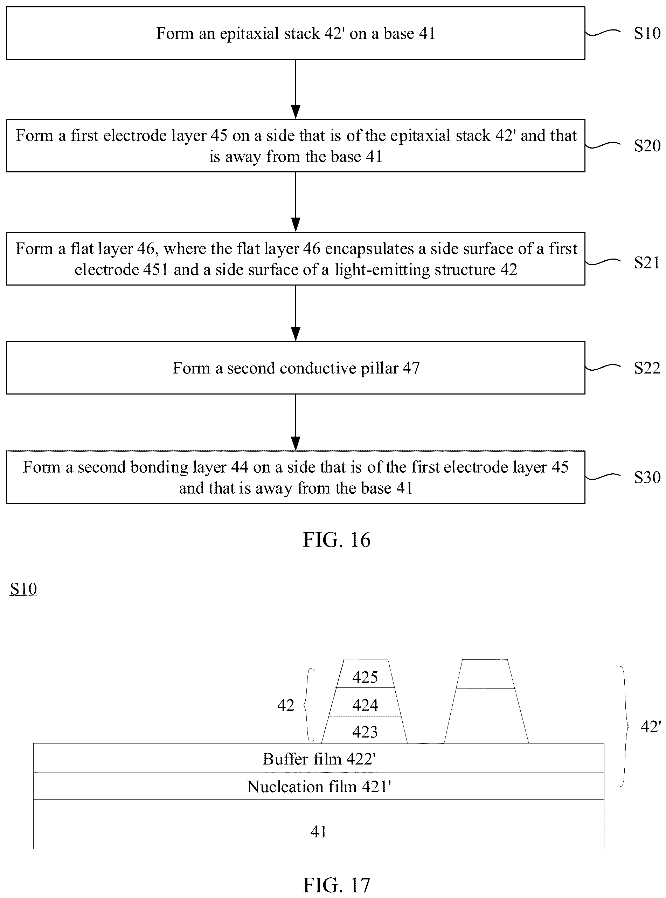

FIG. 16 is a schematic flowchart of preparing an epitaxial wafer according to an embodiment of this application. FIG. 17 to FIG. 22 are diagrams of a process for preparing a wafer according to an embodiment of this application.

An embodiment of this application provides a method for preparing an epitaxial wafer 40. As shown in FIG. 16, the preparation method includes the following steps.

S10: Form an epitaxial stack 42' on a base 41, as shown in FIG. 17.

In some embodiments, step S10 includes the following steps.

Steps S101 to S105 in Example 1 are first performed to form a stack of a nucleation film 421', a buffer film 422', a second semiconductor film 423', an active film 424', and a first semiconductor film 425'.

S106: Pattern the second semiconductor film 423', the active film 424', and the first semiconductor film 425' to form a light-emitting structure 42, as shown in FIG. 17.

For example, patterning is performed by using an exposure, development, and etching process, and the light-emitting structure 42 is used as a micro LED light-emitting pixel (mesa) unit structure.

Based on different structures of the epitaxial stack 42', different film layers are used to perform patterning processing on the epitaxial stack 42'. However, regardless of a structure, the first semiconductor film 425', the active film 424', and the second semiconductor film 423' in the epitaxial stack 42' need to be patterned. As shown in FIG. 17, the light-emitting structure 42 formed by patterning the epitaxial stack 42' includes a first semiconductor layer 425, an active layer 424, and a second semiconductor layer 423, and the nucleation film 421' and the buffer film 422' in the epitaxial stack 42' may not be patterned. Certainly, the nucleation film 421' and the buffer film 422' may alternatively be patterned.

In some embodiments, after step 106 is performed, passivation processing may be further performed on the light-emitting structure 42, to eliminate problems such as etching damage and a surface defect state of the light-emitting structure 42, and improve light-emitting efficiency of the light-emitting structure 42.

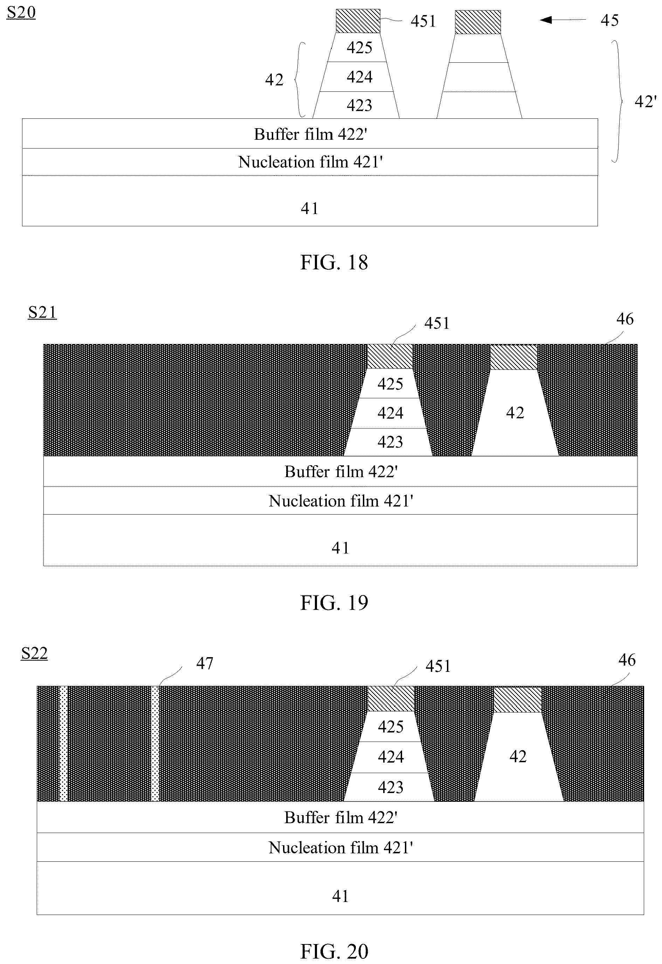

S20: Form a first electrode layer 45 on a side that is of the epitaxial stack 42' and that is away from the base 41, as shown in FIG. 18.

The first electrode layer 45 is located on a side of the first semiconductor layer 425, the first electrode layer 45 includes a plurality of first electrodes 451, and the first electrode 451 is correspondingly connected to the first semiconductor layer 425 in the light-emitting structure 42, and is used as a drive electrode of the light-emitting structure 42.

S21: Form a flat layer 46, where the flat layer 46 encapsulates a side surface of the first electrode 451 and a side surface of the light-emitting structure 42, as shown in FIG. 19.

For example, step S21 includes the following steps.

S211: Deposit the flat film, where the flat film fills a gap between the first electrode 451 and the light-emitting structure 42.

S212: Flatten the flat film by using an etching or chemical mechanical grinding process, to expose the first electrode 451, so as to form the flat layer 46. A material of the flat layer 46 includes, for example, silicon dioxide (SiO₂), silicon nitride (SiN), and the like.

S22: Form a second conductive pillar 47, as shown in FIG. 20.

For example, step S22 includes the following steps.

S221: Perform etching on the flat layer 46 by using an exposure, development, and etching process, to form a via, where a location of the via corresponds to a location of a back-end-of-line metal interconnect pad in a drive circuit layer 32.

S222: Deposit a conductive film, where the conductive film fills the via and covers the flat layer 46.

S223: Flatten the conductive film by using the etching or chemical mechanical polishing process, remove a part that is of the conductive film and that is located above the flat layer 46, and reserve a part that is of the conductive film and that is located in the via as the second conductive pillar 47.

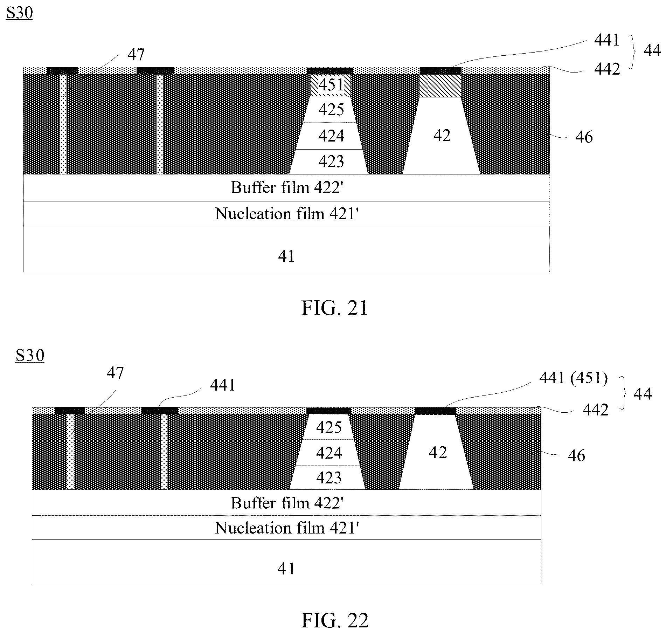

S30: Form a second bonding layer 44 on a side that is of the first electrode layer 45 and that is away from the base 41, as shown in FIG. 21.

In some embodiments, a step of forming the second bonding layer 44 is the same as a step of forming the first bonding layer 33.

For example, step S30 includes the following steps.

S301: Deposit, on a side that is of the flat layer 46 and that is away from the base 41, a second bonding film covering the flat layer 46, the first electrode layer 45, and the second conductive pillar 47, where a material of the second bonding film includes a transparent conductive material.

S302: Pattern the second bonding film to form a second patterned bonding area 441.

A structure of the second patterned bonding area 441 corresponds to the back-end-of-line metal interconnect pad in the drive circuit layer 32, and the first electrode layer 45 is connected to the second patterned bonding area 441.

S303: Form a second dielectric area 442 on the side that is of the flat layer 46 and that is away from the base 41.

The second dielectric area 442 fills a gap area outside the second patterned bonding area 441, and encapsulates a side surface of the second patterned bonding area 441, to implement electrical insulation.

For example, step S303 includes the following steps.

S3031. Deposit, on the side that is of the flat layer 46 and that is away from the base 41, a fourth dielectric film covering the second patterned bonding area 441 and the flat layer 46.

S3032: Flatten the fourth dielectric film by using the etching or chemical mechanical polishing process, to implement surface flatness of the fourth dielectric film, so as to form the second dielectric area 442.

In some embodiments, the epitaxial wafer 40 includes the base 41, the epitaxial stack 42', the first electrode layer 45, and the second bonding layer 44. As shown in FIG. 21, the epitaxial stack 42' includes a plurality of light-emitting structures 42, and the plurality of light-emitting structures 42 are used to emit light of a same color.

The light-emitting structure 42 includes the first semiconductor layer 425, the active layer 424, and the second semiconductor layer 423 that are sequentially provided in a direction away from the second bonding layer 44. The first electrode layer 45 includes the plurality of first electrodes 451. The first electrode 451 is disposed on a side that is of the first semiconductor layer 425 and that is away from the base 41. The first electrode 451 is in contact with the first semiconductor layer 425 and is connected to the second patterned bonding area 441.

The second bonding layer 44 includes the second patterned bonding area 441 and the second dielectric area 442. The second patterned bonding area 441 is arranged in the second dielectric area 442 and extends through the second dielectric area 442 in a thickness direction of the second dielectric area 442.

In some other embodiments, as shown in FIG. 22, the epitaxial wafer 40 does not include the first electrode layer 45, and the second patterned bonding area 441 is reused as the first electrode layer 45. After step S10 is performed, steps S21, S22, and S30 are directly performed.

The second bonding layer 44 includes a plurality of second patterned bonding areas 441 and the second dielectric area 442. The second patterned bonding areas 441 are arranged in the second dielectric area 442 and extend through the second dielectric area 442 in a thickness direction of the second dielectric area 442. A second patterned bonding area 441 that is in the plurality of second patterned bonding areas 441 and that corresponds to a position of the light-emitting structure 42 is reused as the first electrode 451 configured to drive the light-emitting structure 42 to emit light, and the epitaxial wafer 40 does not include an independent first electrode layer 45.

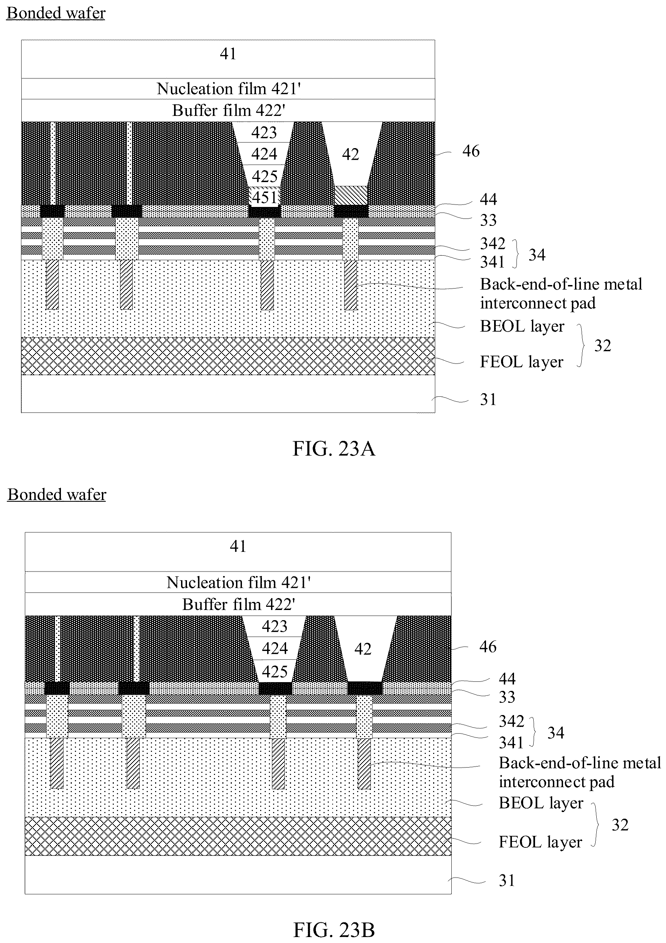

Now, the epitaxial wafer 40 provided in this embodiment of this application is prepared completely. The second bonding layer 44 in the epitaxial wafer 40 provided in this example is a patterned structure, as shown in FIG. 23A and FIG. 23B. When a drive backplane 30 and the epitaxial wafer 40 are subsequently bonded, the first bonding layer 33 and the second bonding layer 44 are bonded by using an alignment process.

### Example 3

The drive backplane 30 and the epitaxial wafer 40 provided in Example 1 and Example 2 are bonded to obtain a bonded wafer. A display module 1 provided in an embodiment of this application may be obtained by processing the bonded wafer.

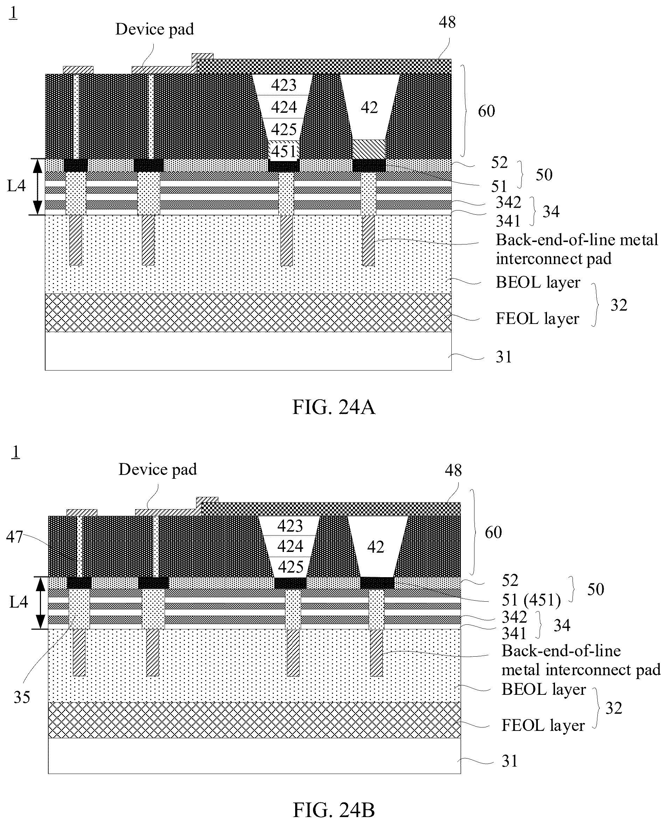

FIG. 24A and FIG. 24B are diagrams of a structure of a display module according to an embodiment of this application.

An embodiment of this application provides a display module 1. As shown in FIG. 24A, the display module 1 includes a substrate 31, and a drive circuit layer 32, a reflective layer 34, a bonding layer 50, and a light-emitting device 60 that are sequentially disposed on a side of the substrate 31.

The drive circuit layer 32 includes, for example, a pixel circuit configured to drive the light-emitting device 60 and a back-end-of-line metal interconnect pad corresponding to the pixel circuit.

The reflective layer 34 includes a first dielectric layer 341 and a second dielectric layer 342 that are stacked, and the first dielectric layer 341 and the second dielectric layer 342 have different refractive indexes. For a structure of the reflective layer 34, refer to the foregoing related descriptions of the reflective layer 34 in the drive backplane 30. Details are not described herein again.

The bonding layer 50 is connected to the light-emitting device 60, and is connected to the drive circuit layer 32 through a first conductive pillar 35, to transmit a signal of the drive circuit layer 32 to the light-emitting device 60.

In the display module 1 provided in this embodiment of this application, the reflective layer 34 includes one or more first dielectric layers 341 and one or more second dielectric layers 342 that are stacked. A quantity of layers, thicknesses, and materials for both the first dielectric layer 341 and the second dielectric layer 342 may be adjusted as required. Structures of the first dielectric layer 341 and the second dielectric layer 342 may be adjusted based on a light-emitting wavelength of the light-emitting device in the display module 1, so that reflectivity of the reflective layer 34 to red light, green light, and blue light can reach 90%, to improve efficiency of the light-emitting device in the display module 1. In addition, because a material of the reflective layer 34 is an inorganic thin film material, and does not need to include a heavy metal material such as silver, there is no heavy metal pollution problem. The reflective layer is compatible with a standard production line process of the drive backplane 30, so that a processing process is simple, and mass production can be implemented at a low cost.

In some embodiments, a material of the bonding layer 50 includes a transparent conductive material.

For example, the bonding layer 50 includes a plurality of patterned bonding areas 51 and a dielectric area 52. The patterned bonding areas 51 are arranged in the dielectric area 52 and extends through the dielectric area 52 in a thickness direction of the dielectric area 52.

The bonding layer 50 is obtained by bonding a first bonding layer 33 in the drive backplane 30 to the second bonding layer 44 in the epitaxial wafer 40. The patterned bonding area 51 is obtained by bonding a first patterned bonding area 331 to a second patterned bonding area 441. The patterned bonding area 51 may have a bonding interface, or may not have a bonding contact surface. The dielectric area 52 is obtained by bonding a first dielectric area 332 in the drive backplane 30 to a second dielectric area 442 in the epitaxial wafer 40.

A plurality of light-emitting devices 60 are disposed corresponding to the plurality of patterned bonding areas 51.

In some embodiments, as shown in FIG. 24A, the light-emitting device 60 includes a first electrode 451, a first semiconductor layer 425, an active layer 424, a second semiconductor layer 423, and a second electrode 48 that are sequentially disposed in a direction away from the bonding layer 50.

In some other embodiments, as shown in FIG. 24B, the light-emitting device 60 includes the first semiconductor layer 425, the active layer 424, the second semiconductor layer 423, and the second electrode 48 that are sequentially disposed in the direction away from the bonding layer 50, and the patterned bonding area 51 that is arranged corresponding to the light-emitting structure 42 is reused as a first electrode 451 in the light-emitting device 60.

The material of the bonding layer 50 includes the transparent conductive material, and the transparent conductive material has high transmittance, so that efficiency of the light-emitting device can be further improved. In addition, because the bonding layer 50 does not include metal such as gold, there is no metal pollution problem. The bonding layer is compatible with a standard production line process, so that a processing process is simple, and mass production can be implemented at a low cost.

In some embodiments, a value of a sum L4 of a thickness of the bonding layer 50 and a thickness of the reflective layer 34 ranges from 100 nm to 2000 nm. For example, the value of the sum L4 of the thicknesses is 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, 1000 nm, 1100 nm, 1200 nm, 1300 nm, 1400 nm, 1500 nm, 1600 nm, 1700 nm, 1800 nm, or 1900 nm.

Based on a feature of the bonding layer 50 provided in this application, the thickness of the bonding layer 50 may be less than 2000 nm, so that a subsequent etching process is easy to perform.

In some embodiments, as shown in FIG. 24B, the display module 1 further includes a plurality of device pads located on a side that is of a flat layer 46 and that is away from the substrate 31. One side of a part of the device pads is connected to the drive circuit layer 32 through a second conductive pillar 47, the patterned bonding area 51, and the first conductive pillar 35, and the other side of the part of the device pads is connected to the second electrode 48, and is configured to transmit the signal of the drive circuit layer 32 to the second electrode 48. The other side of the part of the device pads is used to connect to a component such as a circuit board, and is used to receive an external signal and transmit the external signal to the drive circuit layer 32.

In some embodiments, the light-emitting device 60 in the display module 1 is configured to emit light of a same color.

Structures of the first dielectric layer 341 and the second dielectric layer 342 that are included in the reflective layer 34 in the display module 1 are adjusted based on a light-emitting color of the light-emitting device 60. Therefore, a structure of a reflective layer 34 for emitting red light in the display module 1, a structure of a reflective layer 34 for emitting blue light in the display module 1, and a structure of a reflective layer 34 for emitting green light in the display module 1 may be different. In this way, reflectivity of a reflective layer 34 in each display module 1 to light emitted by the light-emitting device 60 included in the display module 1 may be more than 90%.

The foregoing descriptions are merely specific implementations of this application, but are not intended to limit the protection scope of this application. Any variation or replacement within the technical scope disclosed in this application shall fall within the protection scope of this application. Therefore, the protection scope of this application shall be subject to the protection scope of the claims.

## Claims

1. A drive backplane, comprising:
a substrate;
a drive circuit layer, provided on a side of the substrate;
a reflective layer, provided on a side that is of the drive circuit layer and that is away from the substrate, wherein the reflective layer comprises a first dielectric layer and a second dielectric layer that are stacked, and the first dielectric layer and the second dielectric layer have different refractive indexes; and
a first bonding layer, provided on a side that is of the reflective layer and that is away from the substrate, wherein the first bonding layer is connected to the drive circuit layer through a conductive pillar.

2. The drive backplane according to claim 1, wherein a material of the first bonding layer comprises a transparent conductive material.

3. The drive backplane according to claim 1 or 2, wherein there are a plurality of first dielectric layers and a plurality of second dielectric layers, and the plurality of first dielectric layers and the plurality of second dielectric layers are alternately arranged.

4. The drive backplane according to any one of claims 1 to 3, wherein the first bonding layer covers the reflective layer.

5. The drive backplane according to claim 1, wherein the first bonding layer comprises a first patterned bonding area and a first dielectric area;
the first patterned bonding area is arranged in the first dielectric area and extends through the first dielectric area in a thickness direction of the first dielectric area; and
the drive circuit layer comprises a back-end-of-line metal interconnect pad, and the first patterned bonding area is connected to the back-end-of-line metal interconnect pad through the conductive pillar.

6. The drive backplane according to any one of claims 1 to 5, wherein materials of the first dielectric layer, the second dielectric layer, and the first dielectric area comprise silicon oxide, titanium dioxide, tantalum pentoxide, or niobium pentoxide.

7. The drive backplane according to claim 5, wherein a material of the first patterned bonding area comprises indium tin oxide, aluminum zinc oxide, or transparent conductive oxide.

8. An epitaxial wafer, comprising:
a base;
an epitaxial stack, provided on a side of the base; and
a second bonding layer, provided on a side that is of the epitaxial stack and that is away from the base, wherein a material of the second bonding layer comprises a transparent conductive material.

9. The epitaxial wafer according to claim 8, wherein the second bonding layer covers the epitaxial stack.

10. The epitaxial wafer according to claim 8, wherein the second bonding layer comprises a second patterned bonding area and a second dielectric area, and the second patterned bonding area is arranged in the second dielectric area and extends through the second dielectric area in a thickness direction of the second dielectric area.

11. The epitaxial wafer according to claim 10, wherein the epitaxial stack comprises a second semiconductor layer, an active layer, and a first semiconductor layer that are sequentially stacked on a side of the base, one of the first semiconductor layer and the second semiconductor layer is an N-type semiconductor layer, and the other one of the first semiconductor layer and the second semiconductor layer is a P-type semiconductor layer.

12. The epitaxial wafer according to any one of claims 8 to 11, wherein the epitaxial wafer further comprises a first electrode layer, and the first electrode layer is provided between the second bonding layer and the epitaxial stack.

13. The epitaxial wafer according to claim 10, wherein a material of the second patterned bonding area comprises indium tin oxide, aluminum zinc oxide, or transparent conductive oxide; and a material of the second dielectric area comprises silicon oxide, silicon nitride, titanium dioxide, tantalum pentoxide, or niobium pentoxide.

14. A display module, comprising:
a substrate; and
a drive circuit layer, a reflective layer, a bonding layer, and a plurality of light-emitting devices that are sequentially disposed on a side of the substrate, wherein
the reflective layer comprises a first dielectric layer and a second dielectric layer that are stacked, the first dielectric layer and the second dielectric layer have different refractive indexes, and the bonding layer is connected to the light-emitting devices and is connected to the drive circuit layer through a conductive pillar.

15. The display module according to claim 14, wherein a material of the bonding layer comprises a transparent conductive material.

16. The display module according to claim 14 or 15, wherein the bonding layer comprises a plurality of patterned bonding areas and a dielectric area; the plurality of patterned bonding areas are arranged in the dielectric area and extend through the dielectric area in a thickness direction of the dielectric area; and the light-emitting devices are disposed correspondingly to a part of the plurality of patterned bonding areas.

17. The display module according to any one of claims 14 to 16, wherein a value of a sum of a thickness of the bonding layer and a thickness of the reflective layer ranges from 100 nm to 2000 nm.

18. The display module according to any one of claims 14 to 17, wherein the light-emitting device comprises a first semiconductor layer, an active layer, a second semiconductor layer, and a second electrode that are sequentially disposed in a direction away from the bonding layer, one of the first semiconductor layer and the second semiconductor layer is an N-type semiconductor layer, and the other one of the first semiconductor layer and the second semiconductor layer is a P-type semiconductor layer.

19. An electronic device, comprising a display module and a processor, wherein the processor is configured to control the display module to display an image, and the display module comprises the display module according to any one of claims 14 to 18.

20. A method for preparing a drive backplane, comprising:
forming a drive circuit layer on a substrate;
forming a reflective layer on a side that is of the drive circuit layer and that is away from the substrate, wherein the reflective layer comprises a first dielectric layer and a second dielectric layer that are stacked, and the first dielectric layer and the second dielectric layer have different refractive indexes; and
forming a first bonding layer on a side that is of the reflective layer and that is away from the substrate, wherein the first bonding layer is connected to the drive circuit layer through a conductive pillar.

21. The preparation method according to claim 20, wherein forming the first bonding layer on the side that is of the reflective layer and that is away from the substrate comprises:
depositing, on the side that is of the reflective layer and that is away from the substrate, the first bonding layer covering the reflective layer, wherein a material of the first bonding layer comprises a transparent conductive material.

22. The preparation method according to claim 20, wherein the first bonding layer comprises a first patterned bonding area and a first dielectric area; and forming the first bonding layer on the side that is of the reflective layer and that is away from the substrate comprises:
depositing, on the side that is of the reflective layer and that is away from the substrate, a first bonding film covering the reflective layer, wherein a material of the first bonding film comprises a transparent conductive material;
patterning the first bonding film to form the first patterned bonding area, wherein the first patterned bonding area is connected to the drive circuit layer; and
forming the first dielectric area on the side that is of the reflective layer and that is away from the substrate, wherein the first dielectric area encapsulates a side surface of the first patterned bonding area.

23. A method for preparing an epitaxial wafer, comprising:
forming an epitaxial stack on a base; and
forming a second bonding layer on a side that is of the epitaxial stack and that is away from the base, wherein a material of the second bonding layer comprises a transparent conductive material.

24. The preparation method according to claim 23, wherein forming the second bonding layer on the side that is of the epitaxial stack and that is away from the base comprises:
depositing, on the side that is of the epitaxial stack and that is away from the base, the second bonding layer covering the epitaxial stack.

25. The preparation method according to claim 23, wherein the second bonding layer comprises a second patterned bonding area and a second dielectric area; and forming the second bonding layer on the side that is of the epitaxial stack and that is away from the base comprises:
forming a second bonding film on the side that is of the epitaxial stack and that is away from the base, wherein a material of the second bonding film is a transparent conductive material;
patterning the second bonding film to form a plurality of second patterned bonding areas; and
forming the second dielectric area on the side that is of the epitaxial stack and that is away from the base, wherein the second dielectric area encapsulates a side surface of the second patterned bonding area.

26. The preparation method according to any one of claims 23 to 25, wherein before forming the second bonding layer on the side that is of the epitaxial stack and that is away from the base, the preparation method further comprises:
forming a first electrode layer on the side that is of the epitaxial stack and that is away from the base.
